# EUROPÄISCHE PATENTSCHRIFT

(11) **EP 2 597 426 B1**
(45) Veröffentlichungstag und Bekanntmachung des Hinweises auf die Patenterteilung: **23.10.2013**
(21) Anmeldenummer: 11190742.4
(22) Anmeldetag: 25.11.2011
(51) Int. Cl.: G01D 4/00

(54) **Zähl- und Messpunkt-System zur Messung und Zählung von elektrischer Energie/Elektrizität und Verfahren**
Counting and measuring point system for measuring and counting electrical energy/electricity and method
Système de point de calcul et de mesure et calcul d'énergie électrique/électricité ainsi que procédé

(43) Veröffentlichungstag der Anmeldung: 29.05.2013
(60) Teilanmeldung: 13182585.3
(73) Patentinhaber: ubitricity Gesellschaft für verteilte Energiesysteme mbH, 10829 Berlin (DE)
(72) Erfinder: Hechtfischer, Knut, 14199 Berlin (DE); Pawlitschek, Frank, 10437 Berlin (DE)
(74) Vertreter: Vossius & Partner

(56) Entgegenhaltungen:
- EP-A1- 2 192 386
- EP-A2- 2 258 582

## Beschreibung

### Gebiet der Erfindung

Die Erfindung betrifft allgemein ein Zähl- und Messpunkt-System zur Messung und Zählung der von einer Verbrauchseinheit an einem festen geographischen Punkt aus einer Entnahmevorrichtung entnommenen elektrischen Energie/Elektrizität (Wirk- und/oder Blindarbeit). Die Erfindung betrifft ebenfalls ein Verfahren zum ortsungebundenen Messen, Zählen und Abrechnen von elektrischem Strom.

### Hintergrund der Erfindung

Derzeit erfolgt die Versorgung mit elektrischer Energie/Elektrizität ganz überwiegend über Netzanschlüsse, die einem Grundstück fest zugeordnet sind. Diese Netzanschlüsse sind einem Anschlussnehmer fest zugewiesen. Zum Zweck der Messung, Zählung und Abrechnung der über den Netzanschluss entnommenen elektrischen Energie/Elektrizität sind ortsgebundene Stromzähler fest installiert. Die über den Netzanschluss entnommene oder eingespeiste elektrische Energie/Elektrizität wird so mit dem Anschlussnehmer abgerechnet. Eine Differenzierung danach, welche Person oder welcher Verbraucher an dem gemessenen Anschluss jeweils Energie/Elektrizität entnommen hat, ist nicht vorgesehen.

Die DE 695 09 529 (EP 0 769 218) beschreibt ein Verteilnetzwerk. Sie bietet eine Lösung dafür an, dass die Abrechnung teilnehmerbasiert erfolgen kann und nicht an einen festen geographischen Punkt gebunden ist, wie dies etwa die SE 425 123, die US 4 352 992 oder die EP 0 047 089 vorsehen.

Die DE 695 09 529 beschreibt ein Verteilnetzwerk bestehend aus elektrischen Leitungen, einer Vielzahl von Abgriffsvorrichtungen mit zumindest einer Steckdoseneinrichtung zum Abgreifen elektrischen Stroms und einer Computereinheit, die mit einzelnen oder mehreren Abgriffsvorrichtungen über das Stromnetz kommuniziert. Soweit die Abgriffsvorrichtungen schaltbar sind, sind diese Abgriffsvorrichtungen zudem stromnetzseitig mit einer sogenannten Regelungs- und Steuereinrichtung ausgestattet, die der Identifizierung einer Bedienperson und der Schaltung der Steckdoseneinrichtung dienen.

Die Bedienperson, die eine Energieverbrauchseinheit mit der Abgriffsvorrichtung verbindet, wird von der mit der Abgriffsvorrichtung verbundenen Computereinheit oder der Regelungseinrichtung über einen in der Energieverbrauchseinheit eingebauten Mikroprozessor identifiziert. In dem beschriebenen System identifiziert somit die Abgriffseinrichtung bzw. die damit verbundene Computereinheit die Bedienperson oder die Verbrauchseinheit. Dies ist nur dadurch möglich, dass in dem von der DE 695 09 529 beschriebenen Verteilnetzwerk die Abgriffsvorrichtungen mit eigens hierfür installierten Computereinheiten verbunden werden, da dort erfindungsgemäß die Abgriffsvorrichtungen (in Verbindung mit den jeweils dafür installierten Computereinheiten) die Fähigkeit aufweisen müssen, neben den Informationen über die Abgriffsvorrichtung selbst alle Informationen über sämtliche Systemteilnehmer vorzuhalten oder abzurufen zu können. Der Identifikationsprozess, der der Bedienperson durch Schaltung der Steuereinrichtung die Entnahme von Strom gestattet, findet nach DE 695 09 529 durch eine Kommunikation zwischen einer eigens für eine oder eine kleinere Zahl von Abgriffseinrichtungen installierten Computereinheit und der Abgriffsvorrichtung statt und zwar über Signale, die dem Verteilnetzwerk überlagert werden. Das erfindungsgemäße Verteilungsnetzwerk nutzt die Power-Line-Kommunikation zwischen der Computereinheit und der Abgriffsvorrichtung.

Die EP-A- 2 192 386 beschreibt ein Zähl- und Messpunkt-System zur Zählung und Messung des Verbrauchs oder der Erzeugung elektrischer Energie. Das System weist eine Anzahl von ortsgebundenen, mit dem Stromnetz verbundenen und zur Entnahme oder Einspeisung elektrischer Energie durch Verbrauchs- und/oder Erzeugungseinheiten geeigneten Entnahmevorrichtungen auf. Diese Entnahmevorrichtungen sind mit einer Kennung versehen, mittels derer eine Identifizierung des Anschlussinhabers möglich ist. Das System weist außerdem mindestens eine identifizierbare ortsungebundene funktionale Einheit zur Messung und Zählung der elektrischen Energie, die durch Verbrauchs- und/oder Erzeugungseinheiten an einer oder mehreren ortsgebundenen Entnahmevorrichtungen über einen elektrischen Leiter entnommen bzw. eingespeist wird auf. Die ortsungebundene funktionale Einheit enthält eine Vorrichtung zum Erfassen der Kennung der Entnahmevorrichtung, eine identifizierbare Vorrichtung zum Zählen und Messen der aus der erfassten Entnahmevorrichtung entnommenen und/oder in die Entnahmevorrichtung eingespeisten elektrischen Energie, eine Vorrichtung zum Speichern der ermittelten Zähl- und Messdaten sowie der erfassten Kennung der jeweils genutzten Entnahmevorrichtung, und eine

Vorrichtung zum Auslesen der gespeicherten Daten.

Das in der EP-A- 2 192 386 beschriebene Zähl und Messpunktsystem zeichnet sich unter anderem dadurch aus, dass die Zähltechnik nicht stationär, sondern mobil angeordnet ist. Neben den zahlreichen Vorteilen, die diese Anordnung im Hinblick auf die Kosten der Anschlussstellen und damit die Gesamtkosten der Infrastruktur bietet, führt die mobile Anordnung der Zähltechnik - beispielsweise in einem Fahrzeug - jedoch dazu, dass ein bestimmtes Angriffsszenario denkbar ist:

Der Angreifer des Systems schließt nicht lediglich den als Systemteilnehmer registrierten Verbraucher an die nicht spannungsführende (also zunächst gegen Stromdiebstahl gesicherte) Entnahmevorrichtung an. Stattdessen verbindet er - etwa mittels eines Y-Kabels oder einer sonstigen Vorrichtung - mehrere Verbraucher mit der Entnahmevorrichtung. Erfolgt dann die erfolgreiche Authentifizierung durch den registrierten Verbraucher, wird die Entnahmevorrichtung spannungsführend geschaltet. Der Strom wird dann von allen angeschlossenen Verbrauchern entnommen, aber aufgrund der mobilen Anordnung des Zählers wird nur der Strom gezählt, den der registrierte Verbraucher über den mit ihm verbundenen Leitungszweig entnimmt. Die weiteren Verbraucher nutzen also die Freischaltung durch den legitimierten Verbraucher quasi per "Huckepack" mit, ohne dass Elektrizität, den sie entnehmen oder einspeisen, gezählt wird. Eine verbrauchergerechte Zuordnung und Abrechnung des entnommenen Stroms könnte durch eine derartige Manipulation also umgangen werden.

### Zusammenfassung der Erfindung

Die Erfindung liegt somit die Aufgabe zugrunde, einen Stromdiebstahl-Schutzmechanismus, insbesondere für das bekannte Zähl und Messpunktsystem, bereitzustellen. Diese Aufgabe wird durch den Gegenstand der Ansprüche gelöst. Bevorzugte Weiterbildungen sind in den abhängigen Ansprüchen angegeben.

Anforderung an ein mobiles Zähl- und Messpunktsystems ist es auch, die Kosten für die Ladeinfrastruktur zu senken. Es ist deshalb erforderlich, Schutzmechanismen gegen Angriffe so auszugestalten, dass die Kosten hierfür den Ansatz des Systems, besonders kosteneffizient zu sein, nicht konterkarieren. Das erfindungsgemäße System zeichnet sich dadurch aus, dass gerade kein zweiter, stationär installierter, geeichter Stromzähler infrastrukturseitig erforderlich ist.

Die Erfindung geht von einem Mess- und Zählpunkt-System aus, dass sich zusammensetzt aus einer fest mit dem Stromnetz verbundenen (ortsgebundenen) Entnahme- und/oder Einspeisevorrichtung und einer identifizierbaren ortsungebundenen, funktionalen Einheit zur Messung und Zählung der durch eine Verbrauchseinheit an der ortsgebundenen Entnahme- und/oder Einspeisevorrichtung entnommenen bzw. eingespeiste elektrischen Energie/Elektrizität.

Das erfindungsgemäße System weist eine mehrere ortsgebundene, mit dem Stromnetz verbundene und zur Entnahme elektrischer Energie/Elektrizität durch Verbrauchs-/Erzeugungseinheiten geeignete Entnahme- und/oder Einspeisevorrichtungen auf. Außerdem weist das System mindestens eine identifizierbare ortsungebundene funktionale Einheit zur Messung und Zählung der elektrischen Energie/Elektrizität auf, die durch Verbrauchs-/Erzeugungseinheiten an einer oder mehreren ortsgebundenen Entnahme- und oder Einspeisevorrichtungen konduktiv entnommen bzw. eingespeist wird.

Den ortsgebundenen Entnahme- und/oder Einspeisevorrichtungen ist jeweils eine Messeinrichtung zur Messung mindestens eines physikalischen Parameters zugeordnet, wobei der oder die physikalischen Parameter die durch die jeweilige Entnahme und/oder Einspeisevorrichtung elektrische Energie repräsentieren. Dies kann je nach Anforderung Messung von Strom, Spannung, jeweilige Phase, Leistung, etc. oder Wirk- bzw. Blindarbeit sein.

Der ortsungebundenen funktionalen Einheit ist ebenfalls eine Messeinrichtung zur Messung mindestens eines physikalischen Parameters zugeordnet, der die elektrische Energie repräsentiert, die zwischen der jeweiligen Entnahme- und/oder Einspeisevorrichtung und der Verbrauchs-/Erzeugungseinheit, der die ortsungebundene funktionale Einheit zugeordnet ist, übertragen wird. Die kann je nach Anforderung eine Messung von Strom, Spannung, jeweilige Phase, Leistung, etc. oder Wirk- bzw. Blindarbeit oder mehrere dieser Größen sein. Die Messeinrichtung kann entweder eine gesonderte Einrichtung der ortsungebundenen funktionalen Einheit oder aber auch die in der EP-A- 2 192 386 als Teil der ortsungebundenen funktionalen Einheit beschriebene Vorrichtung zur Messung und Zählung der elektrischen Energie/Elektrizität selbst sein.

Ferner ist in dem erfindungsgemäßen System ein Vergleichsmittel vorgesehen, das den anschlussseitig ermittelten Messwert (also vorzugsweise dem gemessenen Strom und/oder Leistung) mit dem entnahmeseitig bzw. einspeiseseitig ermittelten Messwert (also vorzugsweise Strom und/oder Leistung) vergleicht. Vorzugsweise sind der anschlussseitig gemessene physikalische Parameter und der entnahmeseitig bzw. einspeiseseitig gemessene physikalische Parameter identisch (also jeweils Strom, oder jeweils Leistung, etc.). Alternativ dazu sind der anschlussseitig gemessene physikalische Parameter und der entnahmeseitig bzw. einspeiseseitig gemessene physikalische Parameter verschieden und das Vergleichsmittel ist eingerichtet, die gemessenen physikalische Parameter in miteinander vergleichbare Größen umzurechnen.

Außerdem stellt die Erfindung eine Vorrichtung zur Überwachung der Entnahme bzw. Einspeisung von Elektrizität an ortsgebundenen Entnahme- und/oder Einspeisevorrichtungen bereit. Diese Vorrichtung kann vorzugsweise, aber nicht ausschließlich, in dem erfindungsgemäßen Zähl- und Messpunkt-System genutzt werden. Die Vorrichtung weist eine Messeinrichtung zur Messung mindestens eines physikalischen Parameters auf, der/die elektrische Energie repräsentiert, die zwischen der jeweiligen Entnahme- und/oder Einspeisevorrichtung und der Verbrauchs-/Erzeugungseinheit, der die ortsungebundene funktionale Einheit zugeordnet ist, übertragen wird. Dies kann je nach Anforderung Messung von Strom, Spannung, jeweilige Phase, Leistung, etc. oder Wirk- bzw. Blindarbeit sein. Die Messeinrichtung ist einer ortsungebundenen funktionalen Einheit zugeordnet.

Vorzugsweise erfolgt eine Speicherung der Messwerte. Ferner ist ein Vergleichsmittel vorgesehen, das den entnahme-/einspeiseseitig gemessenen Strom und/oder Leistung (bzw. einen sonst geeigneten Vergleichswert), also zum Beispiel in einem Elektrofahrzeug, mit einem bereitgestellten Messwert von anschlussseitig (ortsgebunden) gemessenem Strom und/oder Leistung (oder einem sonst geeigneten Messwert) vergleicht. Denkbar ist auch, dass aus Messwerten gesondert Vergleichswerte errechnet werden, um z.B. Blind- und Wirkleistung zu berücksichtigen oder um zu berücksichtigen, dass die zu vergleichenden Werte mit verschiedenen Messmethoden und/oder -techniken ermittelt werden, wie bereits oben erläutert.

Vorzugsweise dient die Vorrichtung der Überwachung und Verhinderung der unautorisierten Entnahme von Elektrizität.

In einer alternativen Ausgestaltung weist das erfindungsgemäße System mehrere ortsgebundene, mit dem Stromnetz verbundene und zur induktiven Entnahme oder Einspeisung elektrischer Energie/Elektrizität durch Verbrauchs-/Erzeugungseinheiten geeignete Entnahmevorrichtungen bzw. Einspeisevorrichtungen auf. Ferner weist das System mindestens eine identifizierbare ortsungebundene funktionale Einheit zur Messung und Zählung der elektrischen Energie/Elektrizität auf, die durch Verbrauchs-/Erzeugungseinheiten an einer oder mehreren ortsgebundenen Entnahmevorrichtungen induktiv entnommen bzw. eingespeist wird.

Den Entnahme- und/oder Einspeisevorrichtungen ist jeweils eine Messeinrichtung zur Messung eines physikalischen Parameters zugeordnet, wobei der physikalische Parameter den durch die jeweilige Entnahme und/oder Einspeisevorrichtung fließenden Strom repräsentiert. Dies kann je nach Anforderung Messung von Strom, Spannung, jeweilige Phase, Leistung, etc. oder Wirk- bzw. Blindarbeit sein.

Der ortsungebundenen funktionalen Einheit ist ebenfalls eine Messeinrichtung zur Messung eines physikalischen Parameters zugeordnet, der den Strom repräsentiert, der zwischen der jeweiligen Entnahme- und/oder Einspeisevorrichtung und der Verbrauchs-/Erzeugungseinheit, der die ortsungebundene funktionale Einheit zugeordnet ist, fließt. Die kann je nach Anforderung Messung von Strom, Spannung, jeweilige Phase, Leistung, etc. oder Wirk- bzw. Blindarbeit sein.. Diese Messeinrichtung kann entweder eine gesonderte Einrichtung der ortsungebundenen funktionalen Einheit oder aber auch die in der EP-A- 2 192 386 als Teil der ortsungebundenen funktionalen Einheit beschriebene Vorrichtung zur Messung und Zählung der elektrischen Energie/Elektrizität selbst sein. Ferner ist in dem erfindungsgemäßen System ein Vergleichsmittel vorgesehen, das den anschlussseitig gemessenen Strom und/oder Leistung mit dem entnahmeseitig gemessenen Strom und/oder Leistung, gegebenenfalls mit zusätzlichen Berechnungen, vergleicht.

In dieser alternativen Ausgestaltung dient die oben beschriebene Vorrichtung zur Überwachung der Entnahme/Einspeisung von Elektrizität der Überwachung der induktiven Kopplung zwischen Entnahmevorrichtung/Einspeisevorrichtung und entnehmender/einspeisender Vorrichtung, also der ortsungebundenen funktionalen Einheit.

### Entnahme- und/oder Einspeisevorrichtung

Zunächst wird die ortsgebundene Entnahme- und/oder Einspeisevorrichtung erläutert. Mit Hilfe der fest mit dem Stromnetz verbundenen (ortsgebundenen) Entnahme- und/oder Einspeisevorrichtung werden Verbrauchs- und/oder Erzeugungseinheiten an das Stromnetz angeschlossen. Dies geschieht in der Regel konduktiv. Bei der handelt es sich damit grundsätzlich um eine Steckdose, wobei die Bauart nicht erheblich ist. Möglich sind konduktive Verbindungen verschiedener Art, sei es für einphasigen oder mehrphasigen Wechselstrom, Starkstrom, Gleichstrom etc.

Im Falle einer induktiven Entnahme- und/oder Einspeisevorrichtung kann dies beispielsweise als Leiterschleife ausgebildet sein, die im Boden eingelassen werden kann.

Einer Entnahme- und/oder Einspeisevorrichtung ist eine Einrichtung zur Strom- und/oder Leistungsmessung des durch die jeweilige Entnahmevorrichtung fließenden Stromes zugeordnet. Diese anschlussseitige Messeinrichtung ist eingerichtet, Messungen in gleichen oder ungleichen Zeitabständen durchzuführen und/oder stochastische Messungen in vorgegebenen oder zufälligen Zeitabständen durchzuführen. Außerdem ist die anschlussseitige Messeinrichtung eingerichtet, die Messwerte als Momentanwerte und/oder als Durchschnittswert für Zeitintervalle beliebiger gleichbleibender oder variabler Länge bereit zu stellen.

An der Entnahme- und/oder Einspeisevorrichtung ist jedoch erfindungsgemäß kein Stromzähler vorgesehen.

Die Entnahme- und/oder Einspeisevorrichtung weist ferner vorzugsweise eine Kommunikationseinheit auf, die die ermittelten Messwerte an die Vergleichseinheit übermittelt. Dies kann entweder automatisch geschehen oder auf Aufforderung durch die Vergleichseinheit oder durch die ortsungebundene funktionale Einheit.

Die Entnahme- und/oder Einspeisevorrichtung weist vorzugsweise eine Kennung auf, um den Inhaber der Entnahme- und/oder Einspeisevorrichtung zu Abrechnungszwecken identifizieren zu können. Diese Kennung kann einmalig sein (ggf. sind mehrere Entnahmevorrichtungen einer Person zugeordnet). In der einfachsten Form genügt es, dass die Entnahme- und/oder Einspeisevorrichtung als Kennung eine Nummer aufweist, die z.B. auf die Entnahme- und/oder Einspeisevorrichtung aufgedruckt ist und anhand derer die Entnahme- und/oder Einspeisevorrichtung identifiziert werden kann. Jede andere Form der Kennzeichnung (beispielsweise visuell oder elektronisch) ist ebenfalls möglich. Möglich ist auch die Kennzeichnung der Entnahme- und/oder Einspeisevorrichtung mittels eines Mikroprozessors.

Mit Hilfe der Kennung kann jede Entnahme- und/oder Einspeisevorrichtung einem Abrechnungspartner, also dem Inhaber der eindeutig zugeordnet werden, um die Abrechnung zu ermöglichen. Dies erfolgt beispielsweise durch Abgleich der Kennung mit den in einer Datenbank oder einer sonstigen Vorrichtung hinterlegten Informationen über den Anschlussinhaber. Die Speicherung weiterer Informationen zu der Entnahme- und/oder Einspeisevorrichtung ist möglich.

### Ortsungebundene funktionale Einheit

Weiterer Bestandteil des Zähl- und Messpunkt-Systems ist neben der Entnahmevorrichtung/Einspeisevorrichtung eine nicht fest mit dem Stromnetz verbundene und ortsungebundene funktionale Einheit, die im Wesentlichen aus einem Stromzähler und weiteren (bekannten) Vorrichtungen zur Erfassung der Kennung der Entnahmevorrichtung/Einspeisevorrichtung, zur Speicherung der Mess- und Zähldaten sowie der genutzten Entnahmevorrichtung/Einspeisevorrichtung und einer Vorrichtung zum Auslesen der gespeicherten Daten besteht.

Der ortsungebundenen funktionalen Einheit ist erfindungsgemäß eine Einrichtung zur Strom- und/oder Leistungsmessung des von der jeweiligen Entnahme- und/oder Einspeisevorrichtung zu der Verbrauchs/Erzeugungseinheit, der die funktionale Einheit zugeordnet ist, fließenden Stromes zugeordnet. Diese Messeinrichtung kann Teil der ortsungebundenen funktionalen Einheit sein. Alternativ dazu ist die Messeinrichtung jedoch baulich und gegebenenfalls auch räumlich von der ortsungebundenen funktionalen Einheit getrennt. Die Messeinrichtung kann auch die in der EP-A- 2 192 386 als Teil der ortsungebundenen funktionalen Einheit beschriebene Vorrichtung zur Messung und Zählung der elektrischen Energie/Elektrizität sein. Auch die entnahmeseitige Messeinrichtung ist eingerichtet bzw. geeignet, Messungen in gleichen oder ungleichen Zeitabständen durchzuführen und/oder stochastische Messungen in vorgegebenen oder zufälligen Zeitabständen durchzuführen. Die entnahmeseitige Messeinrichtung ist vorzugsweise ferner eingerichtet, die Messwerte als Momentanwerte und/oder als Durchschnittswert für Zeitintervalle beliebiger gleichbleibender oder variabler Länge bereit zu stellen.

Gemeinsam mit der aufgrund der Kennung identifizierbaren Entnahme- und/oder Einspeisevorrichtung bildet die ortsungebundene funktionale Einheit ein Zähl- und Messpunkt-System. Die ortsungebundene funktionale Einheit ist ihrerseits eindeutig identifizierbar. Dabei ist es möglich, der Einheit eine feste Identität dauerhaft zuzuweisen (zum Beispiel durch Verwendung einer nur einmal vergebenen Stromzählernummer). Neben oder anstelle einer festen Zählernummer ist es darüber hinaus auch möglich, die Einheit durch deren jeweiligen Nutzer mit einer Identität zu versehen (in ähnlicher Weise, wie z. B. ein Mobiltelefon erst durch Einlegen einer SIM-Karte zu einem eindeutig identifizierbaren Systemteilnehmer wird) bzw. die feste Identität zu modifizieren.

Die ortsungebundene funktionale Einheit besteht danach vorzugsweise aus den nachstehenden technischen Vorrichtungen, deren räumliche Anordnung und/oder technische Ausführung variieren kann:

### (1) Vorrichtung zum Erfassen der Kennung der Entnahme- und/oder Einspeisevorrichtung

Es bedarf einer Vorrichtung zum Erfassen der Kennung der Entnahme- und/oder Einspeisevorrichtung, die unterschiedlich ausgestaltet werden kann. Beispielsweise erfolgt die manuelle Erfassung der Kennung durch eine Bedienperson, etwa durch Ablesen der Kennung an der Entnahmevorrichtung und Verzeichnen, Eingeben etc. dieser Kennung in eine dafür geeignete Vorrichtung (z.B. Eingabe in ein hierfür vorgesehenes Gerät). Bevorzugt ist eine automatisierte Erfassung der Kennung. Diese kann sowohl durch den Nutzer erfolgen (indem die Person ein dafür vorgesehenes Gerät zum Einlesen und Speicher der Kennung an die Entnahme- und/oder Einspeisevorrichtung hält und die Kennung in das Gerät eingelesen wird) als auch automatisiert erfolgen (indem die Kennung der Entnahme- und/oder Einspeisevorrichtung unter Nutzung entsprechender technischer Verfahren, z.B. Funk, automatisch ausgelesen wird). Vorzugsweise geschieht dies über Barcode-Kennungen und entsprechende Lesegeräte, oder über RFID-Tags und RFID-Lesegeräte.

### (2) Identifizierbare Vorrichtung zum Zählen und Messen

Ferner ist in der ortsungebundenen funktionalen Einheit eine Vorrichtung zum Zählen und Messen der elektrischen Energie/Elektrizität vorgesehen, die von der Verbrauchs- und/oder Erzeugungseinheit aus der vorher erkannten Entnahme- und/oder Einspeisevorrichtung entnommen und/oder in die Entnahmevorrichtung bzw. Einspeisevorrichtung eingespeist wird. Bei dieser Vorrichtung handelt es sich um einen Stromzähler (vorzugsweise einen bidirektionalen Lastgangzähler für ein- oder mehrphasigen Wechselstrom), wobei dessen Funktionalität im Einzelnen stark variieren kann und vom Einsatzumfeld des ortsungebundenen Zähl- und Messpunktes abhängig ist.

### (3) Vorrichtung zum Speichern von Daten

Darüber hinaus ist eine Vorrichtung zum Speichern der von der funktionalen Einheit ermittelten Zähl- und Messdaten sowie der ermittelten Kennung der jeweils genutzten Entnahme- und/oder Einspeisevorrichtung vorgesehen. Dabei handelt es sich beispielsweise um einen Speicherchip, eine Festplatte oder ein sonstiges Speicherelement, in dem die Daten zur weiteren Verwendung gespeichert oder zumindest zwischengespeichert werden.

### (4) Vorrichtung zur Auslesung der gespeicherten Daten

Schließlich ist eine Vorrichtung zur Auslesung der gespeicherten Daten vorgesehen. Sowohl die Messdaten als auch die Kennung der jeweils benutzten Entnahme- und/oder Einspeisevorrichtung müssen aus dem Speicher auslesbar sein, um weiterverarbeitet werden zu können. Das Auslesen der Daten kann dabei technisch auf verschiedene Arten erfolgen. In der Regel wird es sich um eine Datenschnittstelle handeln, über die die Daten (je nach Art der Schnittstelle) in verschiedener Weise manuell bzw. ganz oder teilweise automatisiert ausgelesen werden können. Möglich ist etwa eine Schnittstelle zur vollautomatischen Fernauslesung, bei der die Daten beispielsweise drahtlos an eine Zentralcomputereinheit übertragen werden. Ebenso ist eine Schnittstelle zur halbautomatischen Auslesung möglich (etwa in dem die Bedienperson das Speichermedium mittels einer Schnittstelle an eine Vorrichtung zur Datenübertragung anschließt und die Daten an eine Zentralcomputereinheit übermittelt). Auch eine Vorrichtung zur manuellen/visuellen Auslesung der Daten ist möglich (z.B. eine Anzeige, von der die sichtbaren Daten händisch oder anderweitig aufgenommen werden und anschließend übermittelt werden können).

Die Anordnung der vorstehend erläuterten Vorrichtungen der funktionalen Einheit kann variiert werden. Insbesondere ist eine enge räumliche Verbindung, etwa dergestalt, dass alle Vorrichtungen an einem Ort, z.B. in einem Gerät, angeordnet werden, nicht erforderlich. Entscheidend ist, dass die vorstehend beschriebenen Vorrichtungen in der beschriebenen Art und Weise als funktionale ortsungebundene Einheit zusammenwirken. Die Vorrichtungen bzw. Komponenten der funktionalen Einheit sind nicht Teil der Entnahmevorrichtung, sondern werden insgesamt oder jedenfalls teilweise außerhalb der Entnahme- und/oder Einspeisevorrichtung, vorzugsweise insgesamt in der Verbrauchs- und/oder Erzeugungseinheit angeordnet. Durch diese Anordnung wird gewährleistet, dass die unter (1) bis (4) beschriebenen Vorrichtungen nur einmal je mobiler Verbrauchs- und oder Erzeugungseinheit benötigt werden. Anders als bei DE 695 09 529 werden zusätzliche Computereinheiten, die mit der Entnahme- und/oder Einspeisevorrichtung kommunizieren oder diese steuern, und/oder eine Kommunikation über Signale, die dem Stromnetz überlagert sind, nicht benötigt. Außer der einfachen Installation der Entnahme- und/oder Einspeisevorrichtung sind deshalb keine Arbeiten an der Stromnetzinfrastruktur notwendig.

Die ortsungebundene funktionale Einheit ist in einer Ausführungsform insgesamt oder teilweise außerhalb der Verbrauchs- und/oder Versorgungseinheit und ganz oder überwiegend außerhalb der Entnahme- und/oder Einspeisevorrichtung eingerichtet, im Sinne eines separaten Moduls. In diesem Fall sind die technischen Vorrichtungen bzw. Komponenten ganz oder teilweise in ein Gerät integriert, das zwischen die Verbrauchs- und/oder Versorgungseinheit und die Entnahme- und/oder Einspeisevorrichtung geschaltet wird. Hierdurch wird erreicht, dass auch Verbrauchs- und/oder Versorgungseinheiten, bei denen die Vorrichtungen (1) bis (4) nicht vollständig integriert sind, die volle Funktionalität eines ortsungebundenen Zähl- und Messpunkts nutzen können.

### Vergleichsmittel

Ferner ist ein Vergleichsmittel in Form einer physischen Vergleichseinheit oder in Form von entsprechender Software vorgesehen, die den entnahmeseitig gemessenen Strom und/oder Leistung mit einem bereitgestellten Messwert von anschlussseitig gemessenem Strom und/oder Leistung vergleicht, wobei zu Vergleichszwecken Berechnungen erforderlich sein können. Das Vergleichsmittel ist vorzugsweise eingerichtet, eine Aktion einzuleiten, wenn die verglichenen Messwerte derart voneinander abweichen, dass ein vorgegebener Differenzschwellwert überschritten wird. Beispielsweise veranlasst das Vergleichsmittel, etwa über eine entsprechende Steuereinheit, dass die Entnahmevorrichtung spannungsfrei geschaltet wird, oder dass die ortsungebundene funktionale Einheit benachrichtigt wird.

Vorzugsweise ist das Vergleichsmittel bzw. die Vergleichseinheit Teil der ortsungebundenen funktionalen Einheit. Alternativ dazu ist das Vergleichsmittel bzw. die Vergleichseinheit Teil der ortsgebundenen Vorrichtung.

Alternativ dazu wird die Vergleichsaufgabe "Remote" durchgeführt, d.h. das Vergleichsmittel ist weder Teil der ortsgebundenen noch der ortsungebundenen Einheit, sondern Teil der Zentralstelle oder Zentralcomputereinheit. Ferner muss der Vergleich nicht zeitgleich mit der Entnahme bzw. Einspeisung, sondern kann auch im Nachgang erfolgen.

Die Kommunikation zwischen der Entnahmevorrichtung und dem Vergleichsmittel/der Vergleichseinheit und/oder der ortsungebundenen, funktionalen Einheit erfolgt drahtlos oder über ein Kabel.

### Erweiterung des Zähl- und Messpunkt-Systems um bevorzugte Ausgestaltungen

Die Funktionalität des erfindungsgemäßen Zähl- und Messpunkt-Systems lässt sich um die im Folgenden bevorzugten Ausgestaltungen erweitern.

Das Erfassen der Kennung der Entnahme- und/oder Einspeisevorrichtung durch die ortsungebundene funktionale Einheit kann vorzugsweise automatisiert werden, indem die Entnahmevorrichtung elektronisch (bspw. mittels eines Mikroprozessors) gekennzeichnet wird und die ortsungebundene funktionale Einheit diese Kennung (ihrerseits unter Verwendung eines Mikroprozessors) ausliest. Denkbar ist hier auch die Anwendung von Verschlüsselungstechnologien, dass heißt eine codierte Datenübertragung. Die erforderliche Kommunikation kann drahtlos (z. B. Bluetooth, WLAN, NFC, etc.) oder über ein Kabel erfolgen, wobei das Kabel auch in die Anschlussleitung zwischen Entnahme- und/oder Einspeisevorrichtung und ortsungebundene funktionale Einheit integriert sein kann. Sofern die ortsungebundene funktionale Einheit in der Verbrauchs- und/oder Erzeugungseinheit platziert ist, kann die "Datenleitung" auch Teil des Anschlusskabels der Verbrauchs- und/oder Erzeugungseinheit sein.

Die ortsungebundene funktionale Einheit kann zusätzlich mit einer Vorrichtung ausgestattet werden, die es erlaubt, das Fortbestehen und die Dauer der elektrischen Verbindung mit der Entnahme- und/oder Einspeisevorrichtung zu messen/überprüfen und zwar in Zeitintervallen oder dauerhaft. Die ermittelte Dauer der elektrischen Verbindung kann in einer entsprechend modifizierten Speichervorrichtung gespeichert werden.

Die ortsungebundene funktionale Einheit ist ferner vorzugsweise so ausgestattet, dass sie einer Verbrauchs- und/oder Erzeugungseinheit (bzw. ihrem Nutzer) nur dann die Entnahme/Einspeisung elektrischer Energie/Elektrizität gestattet, wenn diese berechtigter Systemteilnehmer ist. Hierfür kann die Entnahmevorrichtung mit einem Schalter versehen sein, der (aus Gründen der Betriebs-, Bedienungs- und Rechtssicherheit) einen elektrischen Stromfluss nur dann zulässt, wenn die ortsungebundene funktionale Einheit die Verbrauchs- und/oder Erzeugungseinheit bzw. ihren Nutzer als zur Entnahme/Einspelsung an der Entnahme- und/oder Einspeisevorrichtung berechtigt ausweist.

Gemäß dieser bevorzugten Ausführungsform liest die ortsungebundene funktionale Einheit die Kennung der Entnahme- und/oder Einspeisevorrichtung aus. Anschließend überprüft die ortsungebundene funktionale Einheit bzw. eine mit der Einheit kommunizierende Computereinheit, ob die Einheit zur Entnahme/Einspeisung an der Entnahmevorrichtung berechtigt ist. Ist das Ergebnis positiv, übermittelt die ortsungebundene funktionale Einheit dem elektronischen Schloss der Entnahmevorrichtung ein entsprechendes Signal (gewissermaßen einen elektronischen Schlüssel), das die Schließung des zu der Entnahme- und/oder Einspeisevorrichtung gehörigen Schalters bewirkt.

Die Entnahme- und/oder Einspeisevorrichtung kann schließlich mittels eines elektronischen Schlosses den Schalter auf Aufforderung der ortsungebundenen funktionalen Einheit oder, falls die elektrische Verbindung zwischen der ortsungebundenen funktionalen Einheit und der Entnahme- und/oder Einspeisevorrichtung getrennt wird, wieder öffnen (etwa nachdem das Signal zum Geschlossenhalten des Schalters entfällt) und Spannung und Stromfluss unterbrechen.

Die ortsungebundene funktionale Einheit kann ferner mit einer Vorrichtung zur Kommunikation und Fernauslesung kombiniert werden. Die Verarbeitung der am ortsungebundenen Zähl- und Messpunkt ermittelten und in der ortsungebundene funktionale Einheit gespeicherten Daten müssen zur weiteren Verarbeitung, insbesondere zur Abrechnung, übermittelt werden. Die Übermittlung der gespeicherten Daten (Zähl- und Messdaten sowie Kennung der Entnahme- und/oder Einspeisevorrichtung sowie gegebenenfalls der Verbindungsdauer) ist ein zentraler Bestandteil eines jeden Mess- und Abrechnungssystems. Darüber hinaus ist auch eine Kommunikation in Richtung der ortsungebundenen funktionalen Einheit möglich, z. B. zur Autorisierung der Schaltung der Entnahme- und/oder Einspeisevorrichtung oder zur Übermittlung von weiteren Daten, die ggf. zur Steuerung verwendet werden können.

Die Daten werden mit Hilfe dieser Vorrichtung an eine Computereinheit übermittelt, die sie verarbeitet. Diese Datenverarbeitung bildet die Grundlage für die Abrechnung der durch die jeweilige ortsungebundene funktionale Einheit erfassten Entnahme-/Einspeisevorgänge an einer Entnahmevorrichtung. Die Übermittlung der Daten kann dabei mittels verschiedener Übertragungstechniken erfolgen. Möglich ist insbesondere eine drahtlose, automatisierte Datenfernübertragung durch eine entsprechende Kommunikationsvorrichtung (dauerhaft oder in Intervallen). Eine solche Kommunikationsvorrichtung kann etwa bestehende Mobilfunknetze (mit unterschiedlichen Datenübermittlungsprotokollen), ein Wireless Local Area Network (WLAN) oder sonstige (Mobil-) Funktechnologien nutzen. Die Daten können dabei unverschlüsselt oder - was wünschenswert ist und zur erforderlichen Datensicherheit beiträgt - verschlüsselt übertragen werden.

Möglich ist auch eine Kombination des ortsungebundener Zähl- und Messpunkts mit einer halbautomatisierten Datenübertragung, etwa indem die Bedienperson die Datenübertragung mit Hilfe der ortsungebundenen funktionalen Einheit über eine Schnittstelle (unter Nutzung drahtloser oder drahtgebundener Technologien) manuell initiiert.

Die ortsungebundene funktionale Einheit kann mit einer Datenbank kombiniert werden, in der zu einzelnen oder Gruppen von Entnahme- und/oder Einspeisevorrichtungen (identifizierbar durch deren Kennung) bestimmte Informationen abgelegt sind, die über die Daten, die zur Identifikation der Entnahme- und/oder Einspeisevorrichtung und ihres Inhabers erforderlichen sind, hinausgehen. Dies können zum Beispiel Stromtarife sein, die dem Netzanschluss der Entnahmevorrichtung zugeordnet sind, die Leistungskennzahlen der Entnahme- und/oder Einspeisevorrichtung (mit welcher Leistung kann aus der Entnahme- und/oder Einspeisevorrichtung elektrische Energie/Elektrizität entnommen bzw. eingespeist werden), oder etwaige individuelle Lastprofile der Entnahmevorrichtung, mit denen die Verbrauchs- und/oder Erzeugungseinheit dort elektrische Energie/Elektrizität entnehmen/einspeisen kann.

Mittels dieser Informationen können sämtliche gewünschten Parameter der Entnahme- und/oder Einspeisevorrichtung erfasst und verfügbar gemacht werden. Hierdurch wird es möglich, die Entnahmevorrichtung technisch besonders einfach zu gestalten und bei der Kommunikation nur minimale Datenmengen (nämlich die Anschlusskennung) zu übertragen.

Die Datenbank lässt sich in einer Abwandlung der vorbeschriebenen Ausführung auch ganz oder teilweise auf dem Datenspeicher in der mit der ortsungebundenen funktionalen Einheit kombinierten Datenbank hinterlegen. Über die Kommunikationsschnittstelle der ortsungebundenen funktionalen Einheit kann die Datenbank dann laufend oder in Intervallen aktualisiert werden.

Die ortsungebundene funktionale Einheit kann zusätzlich mit einer Vorrichtung ausgestattet werden, die die Regelung des Verbrauchs oder der Erzeugung elektrischer Energie/Elektrizität einer angeschlossenen Verbrauchs- und/oder Erzeugungseinheit ermöglicht. Hintergrund ist die Möglichkeit einer geregelten Integration von Verbrauchs- und/oder Erzeugungseinheiten in das Stromnetz. Die Vorrichtung zur Regelung ist vorzugsweise innerhalb der Verbrauchs- und/oder Erzeugungseinheit anzuordnen und wird über die Kommunikationsvorrichtung der ortsungebundenen funktionalen Einheit gesteuert. Die Vorrichtung kann so ausgestaltet sein, dass ihr von einer Zentralcomputereinheit drahtlos ein Signal zum Starten oder Beenden oder jeder sonstigen Modifikation des Entnahme-/Einspeisevorgangs an die Verbrauchs- und/oder Erzeugungseinheit übermittelt wird und der Lastgang entsprechend geregelt wird.

Im Folgenden werden bevorzugte Ausführungsbeispiele erläutert.

Die Erfindung kann im Bereich der Elektromobilität eingesetzt werden. Die folgenden bevorzugten Ausführungsbeispiele beschreiben in diesem Bereich typische Anwendungsfälle. Für die folgende Darstellung wird als Verbrauchs- und Erzeugungseinheit ein Elektrofahrzeug gewählt, in das die erfindungsgemäße ortsungebundene funktionale Einheit integriert ist. Ortsungebundene funktionale Einheit und Entnahme- und/oder Einspeisevorrichtung bilden gemeinsam die Voraussetzungen für ein erfindungsgemäßes Zähl- und Messpunkt-System.

### Anschlusserkennung

Bei Anschluss des Elektrofahrzeugs an die Entnahme- und/oder Einspeisevorrichtung ist der in der Entnahmevorrichtung eingebaute Schalter zunächst offen. Es fließt kein Strom. Das Lesegerät in dem Elektrofahrzeug kann nach dem Herstellen der Verbindung zwischen Elektrofahrzeug und Entnahmevorrichtung die Kennung der Entnahme- und/oder Einspeisevorrichtung auslesen. Der Auslesevorgang kann drahtlos oder drahtgebunden erfolgen, etwa mittels des Kabels, mit dem das Elektrofahrzeug an die Entnahme- und/oder Einspeisevorrichtung angeschlossen wird. Die ausgelesene Kennung wird im Speicher abgelegt.

### Autorisierung der ortsungebundenen funktionalen Einheit

Die Kennung wird sodann verwendet, um die Autorisierung des Schaltprozesses für den in der Entnahmevorrichtung eingebauten Schalter zu initiieren. Dies kann dergestalt geschehen, dass das Elektrofahrzeug mittels seines Kommunikationsmoduls die Kennung der Entnahme- und/oder Einspeisevorrichtung an eine Zentralcomputereinheit sendet und diese aufgrund von Daten, die zu der Entnahme- und/oder Einspeisevorrichtung und dem Nutzer des Elektrofahrzeugs hinterlegt sind, an das Elektrofahrzeug ein Signal sendet, das das Elektrofahrzeug bzw. seinen Nutzer als autorisiert oder nicht autorisiert zur Entnahme/Einspeisung von elektrischer Energie/Elektrizität an dem entsprechenden Anschlusspunkt qualifiziert. Dabei kann etwa seitens der Zentralcomputereinheit berücksichtigt werden, ob der Nutzer mit Zahlungen für vorherige Entnahmen in Verzug ist und ob sein Elektrofahrzeug an der entsprechenden Entnahme- und/oder. Einspeisevorrichtung Strom entnehmen kann/soll.

### Kommunikation von Steuerungs-/Regelungsparametem

Darüber hinaus können dem Elektrofahrzeug durch die Zentralcomputereinheit weitere Daten übermittelt werden, die den späteren Entnahmeprozess bestimmen. So kann etwa die zu der Entnahmevorrichtung hinterlegte maximale Ladeleistung, ein bestimmtes Ladeprofil oder ähnliches übermittelt werden. Dies kann in Abstimmung auf weitere Daten (beispielsweise über den Ladestand der Akkumulatoren) erfolgen, die dem Zentralcomputer zuvor über die Kommunikationseinheit übermittelt worden und mit den hinterlegten Daten über die Verbrauchs- und/oder Erzeugungseinheit abgestimmt sind.

### Schaltung der Entnahme- und/oder Einspeisevorrichtung

Erhält das Elektrofahrzeug das Autorisierungssignal, sendet es mittels des verwendeten elektronischen Verfahrens den elektronischen Schlüssel an das elektronische Schloss der Entnahme- und/oder Einspeisevorrichtung. Stimmt das Autorisierungssignal (z.B. ein bestimmter Code) mit den Anforderungen des elektronischen Schlosses überein, schließt dieses den Schalter und elektrische Energie/Elektrizität kann (ggf. unter Berücksichtung der von der Zentralcomputereinheit für diese Entnahmevorrichtung und diesen Teilnehmer übermittelten Restriktionen) entnommen oder eingespeist werden.

In einer Abwandlung ist es auch denkbar, sämtliche Daten zu den einzelnen Entnahme- und/oder Einspeisevorrichtungen, zum Schalt-/Entschlüsselungsprozess, dem Elektrofahrzeug und seinem Nutzer nicht oder nicht ausschließlich auf einer Zentralcomputereinheit, sondern einer Speichereinheit des Elektrofahrzeugs selbst zu hinterlegen. Hierdurch kann die Kommunikation mit der Zentralcomputereinheit bei der Herstellung der Verbindung zunächst entfallen. Die auf dem Speicher hinterlegten Daten werden in dieser Variante mit den auf der Zentralcomputereinheit hinterlegten Daten in regelmäßigen oder unregelmäßigen Abständen (automatisiert oder durch manuelle Einleitung) abgeglichen.

### Lastgangmessung/Zählung

Der in dem Elektrofahrzeug als Teil der funktionalen ortsunabhängigen Einheit eingebaute Elektrizitätszähler (z.B. ein Lastgangzähler) zählt die entnommene/einspeiste Energie/Elektrizität. Der Entnahme-/Einspeisevorgang wird fortgesetzt, bis dieser (i) vom Nutzer des Elektrofahrzeugs (etwa durch Ziehen des Steckers im konduktiven Fall, oder Wegbewegen des Fahrzeugs im induktiven Fall), (ii) durch die Verbrauchs- und/oder Erzeugungseinheit selbst (etwa mangels Bedarfs, z.B. bei vollem Akkumulator) oder - soweit vorhanden - (iii) durch die Regelungsvorrichtung beendet wird. Ein Eingreifen der Regelungsvorrichtung setzt eine entsprechende Aufforderung voraus, die vorzugsweise von der Zentralcomputereinheit an die ortsungebundene funktionale Einheit gesendet und von dieser an die Regelungsvorrichtung weitergegeben wird. Dies schließt eine eigenständige Regelung des Verbrauchs durch das durch das Batteriemanagementsystem des Elektrofahrzeugs nicht aus. Das Messgerät übermittelt den gemessenen Lastgang der Speichereinrichtung - ggf. gemeinsam mit den zeitlichen Rahmendaten der Messung (Beginn/Ende) -, die diesen gemeinsam mit der Information über die Kennung der Entnahmevorrichtung in einem elektronischen Speicher ablegt.

Außerdem wird - sobald der Ladevorgang für den berechtigten Systemteilnehmer (also die Verbrauchs- und/oder Erzeugungseinheit) freigeschaltet ist - der Strom und/oder die Leistung in der Entnahmevorrichtung und in der mobilen, ortsungebundenen funktionalen Einheit (angeordnet im Fahrzeug, im Kabel etc.) gemessen. Dies erfolgt kapazitiv, induktiv oder resistiv und kann beispielsweise durch jeweils einen Messwiderstand, durch einen Hall-Sensor oder durch eine sonstige Messvorrichtung geschehen. Entscheidend ist hier die Unterscheidung zwischen Strommessung und Stromzählung. Während in der ortsungebundenen funktionalen Einheit eine Stromzählung erfolgt und in der Entnahmevorrichtung gerade nicht, erfolgt erfindungsgemäß eine Strommessung auf beiden Seiten, also in der Entnahme- und/oder Einspeisevorrichtung und in der funktionalen Einheit, wobei die Messaufgabe in der ortsungebundenen Einheit vorzugsweise durch die Messtechnik des Zählers übernommen wird.

Die Strommessung erfolgt vorzugsweise auf beiden Seiten laufend und über gleiche Zeitabstände. Die Messung muss jedoch nicht in bestimmten Zeitabständen erfolgen. Statistische Verfahren sind im Sinne der Datenvermeidung bevorzugt. Beispielsweise werden Momentanwerte verarbeitet oder über einen Zeitraum integriert und verglichen. Die Erfindung umfasst ebenfalls Kombinationen aus Momentanwerten und Integralen oder einen Stufenansatz.

Die in der Entnahmevorrichtung und in der mobilen Einheit gemessenen Werte werden dann durch eine Vergleichseinheit (die eine Messtechnik enthalten kann), die sich ganz oder teilweise in der Entnahmevorrichtung und/oder in der mobilen Einheit befindet, verglichen. Wenn die Vergleichsvorrichtung nur in der Entnahme- und/oder Einspeisevorrichtung oder nur in der funktionalen Einheit vorhanden ist, werden die an der jeweils anderen Stelle erfassten Messwerte zur Vergleichseinrichtung übertragen.

Der Vergleich erfolgt laufend und/oder periodisch und/oder in variierenden (zufällig oder nicht zufällig) vorzugsweise parametrierbaren Zeitabständen.

Die Messwerte werden vorzugsweise in einer Steuereinheit elektronisch ausgewertet bzw. anhand parametrierbarer Vorgaben interpretiert. Dabei wird durch ein geeignetes Verfahren entsprechend bestimmter Festlegungen eine Aktion ausgelöst.

Im Falle des konduktiven Ladens kann beispielsweise eine weitere Instanz über eine geeignete Schnittstelle (z. B. automatischer Anruf beim Autofahrer, Rückfrage bei der Leistelle, Nachricht an Infrastrukturpartner, etc.) eingeschaltet, vorgeschaltet und/oder vor, während oder nach der Aktion informiert werden. Weichen die Werte über eine bestimmte Toleranzgrenze hinaus voneinander ab, kann davon ausgegangen werden, dass an der Entnahme- und/oder Einspeisevorrichtung nicht nur der legitimierte Verbraucher, sondern ein oder mehrere nicht legitimierte Verbraucher angeschlossen sind bzw. waren und zusätzlich zum legitimierten Verbraucher Strom entnehmen bzw. entnommen oder eingespeist haben. Überschreitet das Vergleichsergebnis die Toleranzgrenze, wird zum Beispiel die Entnahme- und/oder Einspeisevorrichtung spannungsfrei geschaltet. Andere Aktionen sind ebenfalls alternativ oder zusätzlich denkbar. Zum Beispiel kann der mobile Teilnehmer gesperrt werden.

Vorzugsweise sendet die Steuereinheit an die zentrale Verwaltungseinheit (Leitstelle) ein Alarmsignal. Das Alarmsignal bewirkt, dass künftige Autorisierungen des betroffenen Systemteilnehmers bis zur Beseitigung des Alarms nicht mehr erfolgreich sind und die Anschlussstellen von ihm nicht mehr spannungsführend geschaltet werden können.

Das Spannungsfreischalten der Entnahmevorrichtung kann - je nach Anordnung der Steuereinheit - durch die Entnahme- und/oder Einspeisevorrichtung selbst oder durch die mobile funktionale Einheit erfolgen.

Im Falle des induktiven Ladens kann als ausgelöste Aktion beispielsweise eine Signalisierung an den Autofahrer erfolgen, dass die induktive Kopplung noch nicht oder noch nicht in ausreichendem Maße hergestellt wurde und das Fahrzeug entsprechend relativ zur Entnahme- und/oder Einspeisevorrichtung bewegt werden sollte, um die Kopplung zu optimieren.

### Verbrauchsabrechnung

Ein Kommunikationsmodul, vorzugsweise das des Elektrofahrzeugs, sendet (sofort oder zeitversetzt) die gespeicherten Daten an die Zentralcomputereinheit, welche sie in ihrer Datenbank speichert. Die Daten werden verwendet, um unter Rückgriff auf die in der Datenbank der Zentralcomputereinheit zu der Entnahme- und/oder Einspeisevorrichtung gespeicherten Daten die einzelnen Entnahmevorgänge gegenüber den Beteiligten (Nutzer des Elektrofahrzeugs, Betreiber der Entnahmevorrichtung) abzurechnen. Hierbei können neben der Differenzierung nach einzelnen Entnahme- und/oder Einspeisevorrichtungen auch zeitliche oder sonst zu den Entnahmevorgängen gespeicherte Daten berücksichtigt werden.

Die erfindungsgemäße Lösung ist in vielerlei Hinsicht vorteilhaft.

Die erfindungsgemäße Lösung ermöglicht es vor allem aufgrund der verstärkten Einführung der Elektromobilität, dass
- elektrische Energie/Elektrizität an zahlreichen Punkten (ortsgebunden) aus dem Stromnetz entnommen oder in das Stromnetz eingespeist werden kann ("Entnahmevorrichtungen"), z.B. im öffentlichen Straßenraum, in Parkhäusern etc.
- die an der Entnahmevorrichtung entnommene/eingespeiste Energie/Elektrizität einer Verbrauchs- und/oder Erzeugungseinheit bzw. deren Bedienperson (z.B. Elektrofahrzeug oder dessen Nutzer, nachstehend kurz auch als "Systemteilnehmer" bezeichnet) eindeutig zugeordnet und mit diesem und dem Inhaber der Entnahmevorrichtung abgerechnet werden kann.
   und
- Missbrauch unterbunden werden kann.

Ebenso lässt sich durch die flächendeckende Vorhaltung von Entnahme- und/oder Einspeisevorrichtungen in verschiedenen Parksituationen erreichen, dass die Nutzer ihre Elektrofahrzeuge möglichst häufig und lange an das Stromnetz anschließen und die Elektrofahrzeuge hierdurch für die geregelte und damit sehr wertvolle Integration in das Stromnetz in größerem Umfang zur Verfügung stehen. Je Verbrauchs- und/oder Erzeugungseinheit (z.B. Elektrofahrzeug) wird nach aktuellen Schätzungen mit einen Bedarf von ca. vier Entnahmevorrichtungen (nämlich zuhause, am Arbeitsplatz, beim Einkaufen und bei Freizeitbeschäftigungen) gerechnet. Allein die Installation von Entnahmevorrichtungen genügt jedoch noch nicht, um eine Infrastruktur zu schaffen, die den Ansprüchen der Elektromobilität genügt. Das erfindungsgemäße System ermöglicht es jedoch
- die Verbrauchs- und/oder Erzeugungseinheit (und/oder ihren Nutzer), die elektrische Energie/Elektrizität an einer Entnahmevorrichtung entnehmen möchte, als berechtigten Systemteilnehmer zu identifizieren,
- eine aus Sicherheitsgründen regelmäßig nicht spannungsführende (abgeschaltete) Entnahmevorrichtung nur zur Nutzung frei zu schalten,
- die entnommene oder eingespeiste Energie/Elektrizität zu messen und zu zählen,
- Missbrauch bei der Stromentnahme zu verhindern,
- die Entnahmevorrichtung bei Beendigung der Einspeisung/Entnahme wieder zu sichern (kein Stromfluss möglich, Abschaltung),
- das Ergebnis der Elektrizitätsmessung/-zählung an eine Abrechnungsstelle zu übermitteln und
- die an der entsprechenden Entnahmevorrichtung entnommene/eingespeiste Energie/Elektrizität mit den jeweiligen Inhabern von Entnahme- und/oder Einspeisevorrichtungen und Verbrauchs- und/oder Erzeugungseinheiten abzurechnen.

Die Abrechnung der entnommen elektrischen Energie/Elektrizität ist teilnehmerbasiert (bezogen auf eine Verbrauchs- und/oder Erzeugungseinheit bzw. ihren Nutzer) und nicht ausschließlich bezogen auf einen festen geographischen Punkt möglich.

Um die Kosten für jede Entnahmevorrichtung so gering wie möglich zu halten, stellt die Erfindung eine möglichst einfache technische Infrastruktur für die Entnahme- und/oder Einspeisevorrichtungen bereit.

Die Identifikations-, Kommunikations-, Abrechnungs- und Steuerungsprozesse erfolgen durch Nutzung bereits vorhandener Infrastruktur, so dass es stromnetzseitig keiner Technik über die (einfach gehaltenen und einfach installierbaren) Entnahme- und/oder Einspeisevorrichtungen hinaus bedarf. Auf diese Weise kann sowohl auf den fest installierten Stromzähler als auch auf stromnetzseitige Kommunikation (etwa die Entnahme- und/oder Einspeisevorrichtungen regelnde Computereinheiten) verzichtet werden.

Die Anzahl der für eine ortsungebundene Abrechnung erforderlichen Systemkomponenten wird dadurch begrenzt, dass die Komponenten nicht in das im System am häufigsten erforderliche Element (die Entnahmevorrichtungen), sondern außerhalb davon, vorzugsweise in den Verbrauchs- und/oder Erzeugungseinheiten angeordnet werden.

Über die Entnahme- und/oder Einspeisevorrichtung zu speichernde Informationen (z.B. Inhaber, Stromtarif, genauer Standort, Leistungsspezifikationen) werden nicht auf einer entsprechenden Vorrichtung der Entnahmevorrichtung selbst oder einer eigens für jede oder eine Gruppe von Entnahmevorrichtungen installierten Computereinheit hinterlegt, sondern bevorzugt in einer zentralen Datenbank. Mit Hilfe der Datenbank können jeder Entnahmevorrichtung alle Infonnationen über den Anschluss zugeordnet werden. Die Entnahme- und/oder Einspeisevorrichtung selbst muss lediglich mit einer Kennung, über die sich der Anschlussinhaber identifizieren lässt (zum Beispiel anhand der in der Datenbank hinterlegten Informationen), ausgestattet sein.

Das erfindungsgemäße Zähl- und Messpunkt-System ermöglicht das ortsungebundene sichere Zählen und Messen von aus dem Stromnetz entnommener bzw. in dieses eingespeister elektrischer Energie/Elektrizität auf einfache Weise. Beschrieben wird eine neue Lösung, bei der elektrische Energie/Elektrizität nicht in alleiniger Abhängigkeit eines festen geographischen Netzanschlusspunkts gemessen und gezählt wird, sondern in Abhängigkeit einzelner Verbrauchs- und/oder Erzeugungseinheiten bzw. ihrer Nutzer (Systemteilnehmer), die einen solchen Netzanschlusspunkt nutzen (ortsungebundener Zähl- und Messpunkt).

Die Idee ist auch insoweit vorteilhaft, als die technischen Anforderungen an die Entnahme- und/oder Einspeisevorrichtung (und damit auch die Kosten für jede einzelne Entnahme- und/oder Einspeisevorrichtung) minimiert werden. Insbesondere wird vermieden, dass für jede Entnahme- und/oder Einspeisevorrichtung oder für Gruppen von Entnahme- und/oder Einspeisevorrichtungen zusätzliche Computereinheiten und/oder zusätzliche Technik, insbesondere eine Kommunikation über dem Stromnetz überlagerte Signale erforderlich sind.

Obwohl die Erfindung mittels der Beschreibung dargestellt und detailliert beschrieben ist, ist diese detaillierte Beschreibung illustrativ und beispielhaft zu verstehen und nicht als die Erfindung einschränkend. Es versteht sich, dass Fachleute Änderungen und Abwandlungen machen können, ohne den Umfang der folgenden Ansprüche zu verlassen. Insbesondere umfasst die Erfindung ebenfalls Ausführungsformen mit jeglicher Kombination von Merkmalen, die vorstehend zu verschiedenen Aspekten und/oder Ausführungsformen genannt oder gezeigt sind.

Im Weiteren schließt der Ausdruck "umfassen" und Ableitungen davon andere Elemente oder Schritte nicht aus. Ebenfalls schließt der unbestimmte Artikel "ein" bzw. "eine" und Ableitungen davon eine Vielzahl nicht aus. Die Funktionen mehrerer in den Ansprüchen aufgeführter Merkmale können durch eine Einheit erfüllt sein. Die Begriffe "im Wesentlichen", "etwa", "ungefähr" und dergleichen in Verbindung mit einer Eigenschaft definieren insbesondere auch genau die Eigenschaft.

## Patentansprüche

1. Zähl- und Messpunkt-System zur Zählung und Messung des Verbrauchs und/oder Einspeisung elektrischer Energie/Elektrizität, wobei das System aufweist:
eine oder mehrere ortsgebundene, mit dem Stromnetz verbundene und zur Entnahme/und oder Einspeisung elektrischer Energie/Elektrizität durch Verbrauchs-/Erzeugungseinheiten geeigneten Entnahme- und/oder Einspeisevorrichtungen, und
mindestens eine identifizierbare ortsungebundene funktionale Einheit zur Messung und Zählung der elektrischen Energie/Elektrizität, die durch Verbrauchs-/Erzeugungseinheiten an einer oder mehreren ortsgebundenen Entnahme- und/oder Einspeisevorrichtungen konduktiv über einen elektrischen Leiter oder induktiv entnommen oder eingespeist wird,
**dadurch gekennzeichnet, dass**
den Entnahme- und/oder Einspeisevorrichtungen jeweils eine Messeinrichtung zugeordnet ist, wobei die Messeinrichtung geeignet ist, mindestens einen physikalischen Parameter zu messen, der die durch die jeweilige Entnahme- und/oder Einspeisevorrichtung übertragene elektrische Energie repräsentiert, wobei die Messeinrichtung vorzugsweise auch eine Messwertspeicherung vornimmt; und
der mindestens einen ortsungebundenen funktionalen Einheit eine Messeinrichtung zugeordnet ist, wobei die Messeinrichtung geeignet ist, mindestens einen physikalischen Parameter zu messen, der die elektrische Energie repräsentiert, die zwischen der jeweiligen Entnahme- und/oder Einspeisevorrichtung und der Verbrauchs-/Erzeugungseinheit, der die ortsungebundene funktionale Einheit zugeordnet ist, übertragen wird, wobei die Messeinrichtung vorzugsweise auch eine Messwertspeicherung vornimmt; und
ein Vergleichsmittel vorgesehen ist, das den anschlussseitig gemessenen mindestens einen physikalischen Parameter mit dem entnahmeseitig bzw. einspeiseseitig gemessenen mindestens einen physikalischen Parameter vergleicht.

2. Zähl- und Messpunkt-System nach Anspruch 1, wobei die anschlussseitige Messeinrichtung und/oder die entnahmeseitige bzw. einspeiseseitige Messeinrichtung eingerichtet ist, periodische Messungen in gleichen oder unterschiedlichen Zeitabständen durchzuführen und/oder wobei die anschlussseitige Messeinrichtung und/oder die entnahmeseitige bzw. einspeiseseitige Messeinrichtung eingerichtet ist, stochastische Messungen in vorgegebenen Zeitabständen durchzuführen.

3. Zähl- und Messpunkt-System nach Anspruch 1 oder 2, wobei die anschlussseitige Messeinrichtung und/oder die entnahmeseitige bzw. einspeiseseitige Messeinrichtung eingerichtet ist, die Messwerte als Momentanwerte und/oder als Durchschnittswert für Zeitintervalle beliebiger gleichbleibender oder variabler Länge bereit zu stellen.

4. Zähl- und Messpunkt-System nach einem der vorstehenden Ansprüche, wobei das Vergleichsmittel eingerichtet ist, eine Aktion einzuleiten, wenn die verglichenen Messwerte derart voneinander abweichen, dass ein vorgegebener Differenzschwellwert überschritten wird.

5. Zähl- und Messpunkt-System nach Anspruch 4, wobei das Vergleichsmittel veranlasst, dass die Entnahmevorrichtung geschaltet wird oder werden kann, und/oder dass die ortsungebundene, funktionale Einheit benachrichtigt wird.

6. Zähl- und Messpunkt-System nach einem der vorstehenden Ansprüche, wobei die ortsungebundene, funktionale Einheit das Vergleichsmittel aufweist.

7. Zähl- und Messpunkt-System nach einem der vorstehenden Ansprüche, wobei die Kommunikation zwischen der Entnahme- und/oder Einspeisevorrichtung und der ortsungebundenen, funktionalen Einheit drahtlos oder über ein Kabel erfolgt.

8. Zähl- und Messpunkt-System nach einem der vorstehenden Ansprüche, wobei die Entnahme- und/oder Einspeisevorrichtungen jeweils mit einer Kennung versehen sind, mittels derer eine Identifizierung des Anschlussinhabers möglich ist.

9. Zähl- und Messpunkt-System nach Anspruch 8, wobei die ortsungebundene fullktionale Einheit aufweist:
a. eine Vorrichtung zum Erfassen der Kennung der Entnahme- und/oder Einspeisevorrichtung,
b. eine identifizierbare Vorrichtung zum Zählen und Messen der aus der gemäß (a.) erfassten Entnahme- und/oder Einspeisevorrichtung entnommenen bzw. eingespeisten elektrischen Energie/Elektrizität,
c. eine Vorrichtung zum Speichern der gemäß (b.) ermittelten Zähl- und Messdaten sowie der gemäß (a.) erfassten Kennung der jeweils genutzten Entnahme- und/oder Einspeisevorrichtung, und
d. eine Vorrichtung zum Auslesen der gemäß (c.) gespeicherten Daten.

10. Zähl- und Messpunkt-System nach Anspruch 8 oder 9, wobei
die Entnahme- und/oder Einspeisevorrichtung mit einer elektronischen Kennung und die ortsungebundene funktionale Einheit mit einer Vorrichtung zum elektronischen Erfassen der elektronischen Kennung gemäß ausgestattet sind.

11. Zähl- und Messpunkt-System nach einem der Ansprüche 1 bis 10, wobei die ortsungebundene funktionale Einheit mit einer Vorrichtung zur Kommunikation und Fernauslesung der gespeicherten Daten ausgestattet ist.

12. Zähl- und Messpunkt-System nach einem der Ansprüche 1 bis 11, wobei die der mindestens einen ortsungebundenen funktionalen Einheit zugeordnete Messeinrichtung auch zur Stromzählung geeignet eingerichtet ist.

13. Zähl- und Messpunkt-System nach einem der Ansprüche 1 bis 13, wobei der mindestens eine anschlussseitig gemessene physikalische Parameter und der mindestens eine entnahmeseitig bzw. einspeiseseitig gemessene physikalische Parameter (i) identisch sind, oder (ii) verschieden sind und das Vergleichsmittel eingerichtet ist, die gemessenen physikalische Parameter in miteinander vergleichbare Größen umzurechnen.

14. Vorrichtung zur Überwachung der Entnahme bzw. Einspeisung von Elektrizität an Entnahme- und/oder Einspeisevorrichtungen, vorzugsweise in einem Zähl- und Messpunkt-System nach einem der vorstehenden Ansprüche, mit
einer der ortsungebundenen funktionalen Einheit zugeordneten Messeinrichtung zur Messung mindestens eines physikalischen Parameters, der die elektrische Energie repräsentiert, die zwischen der jeweiligen Entnahme- und/oder Einspeisevorrichtung und der Verbrauchs-/Erzeugungseinheit, der die ortsungebundene funktionale Einheit zugeordnet ist, übertragen wird; und
einem Vergleichsmittel, das den mindestens einen entnahmeseitig bzw. einspeiseseitig gemessenen physikalischen Parameter mit einem bereitgestellten Messwert von mindestens einem anschlussseitig gemessenen physikalischen Parameter vergleicht.

15. Verfahren zum ortsungebundenen Messen und Zählen sowie Abrechnen der von einer Verbrauchs-/Erzeugungseinheit entnommenen bzw. eingespeisten elektrischen Energie/Elektrizität mittels mindestens einem Zähl- und Messpunkt-System nach einem der Ansprüche 1 bis 13, mit den Schritten:
a. konduktives Anschließen oder induktives Koppeln der identifizierbaren ortsungebundenen, funktionalen Einheit für eine nach geschaltete Verbrauchs-/Erzeugungseinheit an eine bzw. mit einer Entnahme- und/oder Einspeisevorrichtung;
b. Zählen und Messen der aus der erfassten Entnahme- und/oder Einspeisevorrichtung entnommenen bzw. eingespeisten elektrischen Energie/Elektrizität; und währenddessen
c. Messen, und vorzugsweise Messwertspeichern, mindestens eines physikalischen Parameters, der die durch die jeweilige Entnahme und/oder Einspeisevorrichtung elektrische Energie repräsentiert; und
d. Messen, und vorzugsweise Messwertspeichern, mindestens eines physikalischen Parameters, der die elektrische Energie repräsentiert, die zwischen der jeweiligen Entnahme- und/oder Einspeisevorrichtung und der Verbrauchs-/Erzeugungseinheit, der die ortsungebundene funktionale Einheit zugeordnet ist, übertragen wird; und
e. Vergleichen des mindestens einen anschlussseitig gemessenen physikalischen Parameters mit dem mindestens einen entnahmeseitig bzw. einspeiseseitig gemessenen physikalischen Parameter.

16. Verfahren nach Anspruch 15, wobei in den Schritten c) und d) periodische Messungen in gleichen oder ungleichen Zeitabständen und/oder stochastische Messungen in vorgegebenen oder zufälligen Zeitabständen durchgeführt werden.

17. Verfahren nach Anspruch 15 oder 16, wobei in Schritt e) eine Aktion eingeleitet wird, wenn die verglichenen Messwerte derart voneinander abweichen, dass ein vorgegebener Differenzschwellwert überschritten wird.

## Claims

1. A metering and measuring point system for metering and measuring electrical energy/electricity consumption and/or generation, wherein the system comprises:
one or more stationary drawing off and/or feeding devices that are connected to the power supply and configured for drawing off and/or feeding in electrical energy/electricity by means of consumption and/or generation units; and
at least one identifiable non-stationary functional unit for measuring and metering electrical energy/electricity that is conductively via an electric conductor or inductively drawn off or fed into one or more stationary drawing off and/or feeding devices by consumption and/or generation units,
**characterized in that**
a measuring means is associated with each drawing off and/or feeding device, wherein the measuring means is adapted to measure at least one physical parameter representing the electrical energy transmitted through the associated drawing off and/or feeding device, wherein the measuring means preferably performs storing of the measurement value; and
a measuring means is associated with the at least one non-stationary functional unit, wherein the measuring means is adapted to measure at least one physical parameter representing the electrical energy transmitted between the associated drawing off and/or feeding device and the consumption and/or generation unit the non-stationary functional unit is associated with, wherein the measuring means preferably also performs storing of the measurement value; and
a comparing means is provided that compares the at least one physical parameter measured at the connecting side with the at least one physical parameter measured at the drawing off or feeding side, respectively.

2. The metering and measuring point system according to claim 1, wherein the measuring means at the connection side and/or the measuring means at the drawing off or feeding side is configured to perform periodic measurements in equal or varying time intervals and/or wherein the measuring means at the connection side and/or the measuring means at the drawing off or feeding side is configured to perform stochastic measurements in predetermined time intervals.

3. The metering and measuring point system according to claim 1 or 2, wherein measuring means at the connection side and/or the measuring means at the drawing off or feeding side to provide the measurements values as instant values and/or average values for time intervals of arbitrary constant or variable length.

4. The metering and measuring point system according to any one of the preceding claims, wherein the comparing means is configured to initiate an action if the compared measurement values deviate from each other such that a predetermined difference threshold level is exceeded.

5. The metering and measuring point system according to claim 4, wherein the comparing means causes that the feeding off device is switched or can be switched and/or that the non-stationary functional unit is notified.

6. The metering and measuring point system according to any one of the preceding claims, wherein the non-stationary functional unit comprises the comparing means.

7. The metering and measuring point system according to any one of the preceding claims, wherein communication between the drawing off and/or feeding device and the non-stationary functional unit is wireless or by cable.

8. The metering and measuring point system according to any one of the preceding claims, wherein the drawing off and/or feeding devices are each provided with an identifier enabling the identification of the grid connection subscriber.

9. The metering and measuring point system according to claim 8, wherein the non-stationary functional unit comprises:
a. a device for detecting the identifier of the drawing off and/or feeding device;
b. an identifiable device for metering and measuring the electrical energy/electricity drawn from and/or fed into the drawing off and/or feeding device detected according to (a);
c. a device for storing the metering and measuring data determined according to (b) as well as the identifier of the respective drawing off and/or feeding device in use as detected according to (a); and
d. a device for reading out the data stored according to (c).

10. The metering and measuring point system according to claim 8 or 9, wherein the drawing off and/or feeding device is provided with an electronic identifier and the non-stationary functional unit is provided with a device for the electronic detection of the electronic identifier.

11. The metering and measuring point system according to any of claims 1 to 10, wherein the non-stationary functional unit is provided with a device for communication and remote readout of the stored data.

12. The metering and measuring point system according to any of claims 1 to 11, wherein the measuring means associated with the at least one non-stationary functional unit is configured to be suitable for current metering.

13. The metering and measuring point system according to any of claims 1 to 12, wherein the at least one physical parameter measured at the connection side and the at least one physical parameter measured at the drawing off or feeding side are (i) identical, or (ii) different and wherein the comparing means is configured to convert the measured physical parameters in units comparable with each other.

14. Device for monitoring the drawing off or feeding into, respectively, of electricity at drawing off and/or feeding devices, preferably in a metering and measuring point system according to any of the preceding claims, comprising
a measuring means being associated with the non-stationary functional unit for measuring at least one physical parameter representing the electrical energy transmitted between the associated drawing off and/or feeding device and the consumption and/or generation unit the non-stationary functional unit is associated with; and
a comparing means that compares the at least one physical parameter measured at the drawing off or feeding side, respectively, with a provided measurement value of at least one physical parameter measured at the connection side.

15. A method of measuring and metering as well as rendering an account of the electrical energy/electricity drawn off and/or fed in by a consumption and/or generation unit regardless of location, using at least one metering and measuring point system according to any of claims 1 to 13, comprising the steps of:
a. conductively connecting or inductively coupling the identifiable non-stationary functional unit for a downstream consumption and/or generation unit to a or with a drawing off and/or feeding device;
b. metering and measuring the electrical energy/electricity drawn off from or fed into the detected drawing off and/or feeding device; and concurrently
c. measuring, and preferably storing measurement value, at least one physical parameter representing the electrical energy transmitted through the associated drawing off and/or feeding device;
d. measuring, and, preferably storing measurement value, at least one physical parameter representing the electrical energy transmitted between the associated drawing off and/or feeding device and the consumption and/or generation unit the non-stationary functional unit is associated with; and
e. comparing the at least one physical parameter measured at the connecting side with the at least one physical parameter measured at the drawing off or feeding side, respectively.

16. The method according to claim 15, wherein in steps c) and d) periodic measurements in equal or unequal time intervals and/or stochastic measurements in predetermined or random time intervals are performed.

17. The method according to claim 15 or 16, wherein in step e) an action is initiated if the compared measurement values deviate from each other such that a predetermined difference threshold level is exceeded.

## Revendications

1. Système de comptage et de points de mesure pour le comptage et la mesure de la consommation et/ou de la distribution d'énergie électrique/d'électricité, ledit système comprenant :
un ou plusieurs dispositifs de prélèvement et/ou de distribution fixes, reliés au réseau de courant et appropriés au prélèvement et/ou à la distribution d'énergie électrique/d'électricité par l'intermédiaire d'unités de consommation/de génération, et
au moins une unité fonctionnelle portable identifiable, pour la mesure et le comptage de l'énergie électrique/de l'électricité conductivement au moyen d'un conducteur électrique ou inductivement prélevée ou distribuée par l'intermédiaire d'unités de consommation/de génération sur un ou plusieurs dispositifs de prélèvement et/ou de distribution fixes,
**caractérisé**
**en ce qu'**un dispositif de mesure est associé à chacun des dispositifs de prélèvement et/ou de distribution, ledit dispositif de mesure étant apte à mesurer au moins un paramètre physique représentant l'énergie électrique transmise par le dispositif de prélèvement et/ou de distribution correspondant, ledit dispositif de mesure procédant aussi préférentiellement à une sauvegarde de valeur de mesure ; et
**en ce qu'**un dispositif de mesure est respectivement associé à l'unité ou aux unités fonctionnelles portables, ledit dispositif de mesure étant apte à mesurer au moins un paramètre physique représentant l'énergie électrique transmise entre le dispositif de prélèvement et/ou de distribution correspondant et l'unité de consommation/de génération associée à l'unité fonctionnelle portable, ledit dispositif .de mesure procédant aussi préférentiellement à une sauvegardé de valeur de mesure ; et
**en ce qu'**il est prévu un moyen de comparaison, comparant le ou les paramètres physiques mesurés côté connexion avec le ou les paramètres physiques mesurés côté prélèvement ou côté distribution.

2. Système de comptage et de points de mesure selon la revendication 1, où le dispositif de mesure côté connexion et/ou le dispositif de mesure côté prélèvement ou côté distribution sont prévus pour effectuer des mesures périodiques à des intervalles temporels égaux ou différents, et/ou où le dispositif de mesure côté connexion et/ou le dispositif de mesure côté prélèvement ou côté distribution sont prévus pour effectuer des mesures stochastiques à des intervalles temporels prescrits.

3. Système de comptage et de points de mesure selon la revendication 1 ou 2, où le dispositif de mesure côté connexion et/ou le dispositif de mesure côté prélèvement ou côté distribution sont prévus pour délivrer les valeurs de mesure en tant que valeurs actuelles et/ou en tant que valeur moyenne pour des intervalles temporels de longueur constante ou variable quelconque.

4. Système de comptage et de points de mesure selon l'une des revendications précédentes, où le moyen de comparaison est prévu pour déclencher une action si les valeurs de mesure comparées diffèrent l'une de l'autre de manière à dépasser une valeur seuil différentielle de consigne.

5. Système de comptage et de points de mesure selon la revendication 4, où le moyen de comparaison permet que le dispositif de prélèvement soit activé ou puisse être activé, et/ou que l'unité fonctionnelle portable soit informée.

6. Système de comptage et de points de.mesure selon l'une des revendications précédentes, où l'unité fonctionnelle portable est pourvue du moyen de comparaison.

7. Système de comptage et de points de mesure selon l'une des revendications précédentes, où la communication entre le dispositif de prélèvement et/ou de distribution et l'unité fonctionnelle portable s'effectue sans fil ou par l'intermédiaire d'un câble.

8. Système de comptage et de points de mesure selon l'une des revendications précédentes, où les dispositifs de prélèvement et/ou de distribution sont pourvus chacun d'un identifiant permettant une identification du propriétaire de la connexion.

9. Système de comptage et de points de mesure selon la revendication 8, où l'unité fonctionnelle portable comprend :
a. un dispositif de saisie de l'identifiant du dispositif de prélèvement et/ou de distribution,
b. un dispositif identifiable pour le comptage et la mesure de l'énergie électrique/de l'électricité prélevée ou distribuée du dispositif de prélèvement et/ou de distribution, saisie conformément à (a.),
c. un dispositif pour la mémorisation des données de comptage et de mesure déterminées conformément à (b.) et de l'identifiant, saisi conformément à (a.), de chaque dispositif de prélèvement et/ou de distribution utilisé, et
d. un dispositif pour la lecture des données mémorisées conformément à (c.).

10. Système de comptage et de points de mesure selon la revendication 8 ou 9, où le dispositif de prélèvement et/ou de distribution est pourvu d'un identifiant électronique, et l'unité fonctionnelle portable d'un dispositif pour la saisie électronique de l'identifiant électronique.

11. Système de comptage et de points de mesure selon l'une des revendications 1 à 10, où l'unité fonctionnelle portable est pourvue d'un dispositif pour la communication et la lecture à distance des données mémorisées.

12. Système de comptage et de points de mesure selon l'une des revendications 1 à 11, où le dispositif de mesure associé à l'unité ou aux unités fonctionnelles portables est également prévu pour être approprié au comptage de courant.

13. Système de comptage et de points de mesure selon l'une des revendications 1 à 12, où le ou les paramètres physiques mesurés côté connexion et le ou les paramètres physiques mesurés côté prélèvement ou côté distribution (i) sont identiques, ou (ii) sont différents, et où le moyen de comparaison est prévu pour convertir les paramètres physiques mesurés en grandeurs comparables entre elles.

14. Dispositif de surveillance du prélèvement ou de la distribution d'électricité sur des dispositifs de prélèvement et/ou de distribution, préférentiellement dans un système de comptage et de points de mesure selon l'une des revendications précédentes, avec
un dispositif de mesure associé à l'unité fonctionnelle portable, pour la mesure d'au moins un paramètre physique représentant l'énergie électrique transmise entre le dispositif de prélèvement et/ou de distribution correspondant et l'unité de consommation/de génération associée à l'unité fonctionnelle portable ; et
un moyen de comparaison, comparant le ou les paramètres physiques mesurés côté prélèvement ou distribution avec une valeur de mesure délivrée d'au moins un paramètre physique mesuré côté connexion.

15. Procédé pour la mesure et le comptage sur un poste portable ainsi que pour la facturation d'une énergie électrique/électricité prélevée ou distribuée d'une unité de consommation/de génération, au moyen d'au moins un système de comptage et de points de mesure selon l'une des revendications 1 à 13, comprenant les étapes suivantes :
a. raccordement conductif ou couplage inductif de l'unité fonctionnelle portable identifiable pour une unité de consommation/de génération située en aval sur un dispositif de prélèvement et/ou de distribution ;
b. comptage et mesure de l'énergie électrique/de l'électricité prélevée ou distribuée du dispositif de prélèvement et/ou de distribution saisi ; et simultanément
c. mesure, et préférentiellement sauvegarde de valeur de mesure d'au moins un paramètre physique représentant l'énergie électrique transmise par le dispositif de prélèvement et/ou de distribution correspondant ; et
d. mesure, et préférentiellement sauvegarde de valeur de mesure d'au moins un paramètre physique représentant l'énergie électrique transmise entre le dispositif de prélèvement et/ou de distribution correspondant et l'unité de consommation/de génération associée à l'unité fonctionnelle portable ; et
e. comparaison du ou des paramètres physiques mesurés côté connexion avec le ou les paramètres physiques mesurés côté prélèvement ou distribution.

16. Procédé selon la revendication 15, où, en étapes c) et d), des mesures périodiques sont effectuées à des intervalles temporels égaux ou différents, et/ou des mesures stochastiques à des intervalles temporels prescrits ou aléatoires.

17. Procédé selon la revendication 15 ou 16, où, en étape e), une action est déclenchée si les valeurs de mesure comparées diffèrent l'une de l'autre de manière à dépasser une valeur seuil différentielle de consigne.
